# EUROPEAN PATENT SPECIFICATION

(11) **EP 1 347 637 B1**
(45) Date of publication and mention of the grant of the patent: **10.05.2006**
(21) Application number: 03251738.5
(22) Date of filing: 20.03.2003
(51) Int. Cl.: H04N 5/225

(54) **Image pickup device**
Bildaufnahmegerät
Dispositif de prise de vues

(30) Priority: 22.03.2002 JP 2002081877
(43) Date of publication of application: 24.09.2003
(73) Proprietor: Konica Minolta Opto, Inc., Hachioji-shi, Tokyo (JP)
(72) Inventor: Honda, Yuichi, c/o Konica Corporation, Hachioji-shi, Tokyo 192-8505 (JP); Atarashi, Yuichi, c/o Konica Corporation, Hachioji-shi, Tokyo 192-8505 (JP); Mizukami, Masafumi, c/o Konica Corporation, Hachioji-shi, Tokyo 192-8505 (JP); Tansho, Kazuo, c/o Konica Corporation, Hachioji-shi, Tokyo 192-8505 (JP)
(74) Representative: Nicholls, Michael John

(56) References cited:
- EP-A- 0 585 186
- EP-A- 0 773 673
- EP-A- 1 130 905
- EP-A- 1 223 749
- US-A- 5 024 509
- US-A- 5 122 909
- US-A- 5 548 450
- US-A- 6 122 114

## Description

The present invention relates to an image pickup device capable of being mounted on a cellphone or on a personal computer.

With high efficiency and downsizing of image pickup devices in recent years, a cellphone and a personal computer each being provided with an image pickup device are spreading.

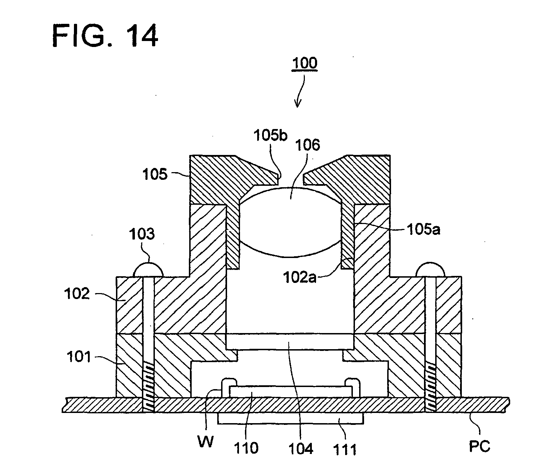

An example of the conventional image pickup device of this kind is shown in Fig. 14. In image pickup device 100 shown in Fig. 14, image sensor 110 is arranged on base board PC which is of glass epoxy, and is connected to image processing IC circuit 111 arranged on the reverse side of the base board PC through a number of wires W coming from a terminal (not shown) on the top.

First casing 101 is arranged on the base board PC in a way to cover the image sensor 110, and on the first casing 101, there is placed second casing 102 so that both the first casing 101 and the second casing 102 are fixed collectively on the base board PC by bolts 103. Between the first casing 101 and the second casing 102, there is arranged infrared blocking filter 104.

An upper portion of the second casing 102 is cylindrical, and when female screw 102a formed on the inner surface of the cylindrical portion is engaged with male screw 105a, lens barrel 105 housing therein lens 106 is fixed on the second casing 102 in a way to be adjusted in terms of position in the direction of an optical axis. Aperture portion 105b is formed on the upper portion of the lens barrel 105.

However, in the conventional image pickup device of this kind, there is a problem of manufacturing cost because of a number of parts, and it is time-consuming to incorporate a number of small-sized parts, and it is necessary to conduct adjustment of relative position in the direction of an optical axis between image sensor 110 and lens 106 while turning the lens barrel 105, in the course of incorporating.

Further, since the lens barrel 105 is rotatable, if the lens barrel 105 is rotated by a vibration or the like after adjustment of relative position between image sensor 110 and lens 106, a light-converging position is shifted, which is a problem.

EP 0,773,673-A discloses an image pickup device in accordance with the pre-characterising portion of claim 1.

An object of the invention is to provide an image pickup device wherein a lens can be positioned easily and accurately in the three directions of three axes each being at right angles to others.

The invention provides an image pickup device according to claim 1.

In the invention, the optical member is urged by a pressing member with prescribed pressing force to be brought into direct contact with the base board or the image sensor. Therefore, it is possible to adjust a focusing position of the lens portion in the direction of an optical axis, by incorporating an image pickup device by stabilizing dimensional accuracy of each constituent member of the image pickup device, and to make adjustment about a focusing position of the lens section in the direction of an optical axis to be unnecessary, in the course of and after incorporating. Further, owing to the rotation-preventing mechanism provided on the interfitting position where the optical member is fitted in the outer frame member, a position of the lens portion in the rotational direction is determined, and rotation of the lens portion is prevented.

Accordingly, a lens can be positioned easily and accurately in the directions of three axes each being at right angles to others.

The interfitting part where the optical member is fitted in the outer frame member is preferably in a D-shaped form that is formed by an arc representing the interfitting part and by a chord connecting both ends of the arc on a plane that is perpendicular to the optical axis. This means that a position of the lens portion in the rotational direction is determined, and rotation of the lens portion is prevented.

Accordingly, a lens can be positioned easily and accurately in the directions of three axes each being at right angles to others.

Preferably, the interfitting part is provided to be closer to the lens portion side than to the contact part. Then, when the optical member is inserted in the outer frame member from the upper portion for assembling, the contact part is brought into contact first, and then, the interfitting part is fitted. Under the condition that the outer frame member is inserted in the contact part, therefore, it is easy to assemble because of the degree of freedom in the rotational direction.

Preferably, the outside diameter of the interfitting part is greater than that of the contact part.

In this case, the optical member does not slip off even when the outer frame member is glued on the base board after the optical member is fitted in the outer frame member, because the outside diameter of the interfitting part is greater than that of the contact part.

Preferably, the rotation-preventing mechanism is provided with a projection portion that is provided on the optical member side and is projected toward the outer frame member, and a groove portion that is provided on the outer frame member side and is engaged with the projection portion.

In this case, since the rotation-preventing mechanism is provided with a projection portion that is provided on the optical member side and is projected toward the outer frame member and with a groove portion that is provided on the outer frame member side and is engaged with the projection portion, rotation of the optical member is surely prevented.

Preferably, the rotation-preventing mechanism is provided with a groove portion that is provided on the optical member side and a projection portion that is provided on the outer frame member and is engaged with the groove portion.

In this case, since the rotation-preventing mechanism is provided with a groove portion that is provided on the optical member side and a projection portion that is engaged with the groove portion, rotation of the optical member can surely be prevented.

Preferably, the projection portion has a narrow form that is tapered downward, and the groove portion has a shape corresponding to the taper of the projection portion.

In this case, since the projection portion has a narrow form that is tapered downward, and the groove portion has a shape corresponding to the taper of the projection portion, positioning accuracy for preventing rotation can be improved.

Preferably, there is provided a cover member that is attached on the outer frame member and is fixed by applying prescribed pressing force on the pressing member.

In this case, since prescribed pressing force is applied on the pressing member by a cover member, it is possible to urge the optical member against the image sensor with stable elastic force even when deformation such as a warp is caused on parts by an aging change, despite that positioning of the optical member and the image sensor in the direction of an optical axis is easy, and it is possible to control backlash of the optical member in the case where vibration is caused accordingly, and when an impact is given as well, it is prevented that excessive stress builds up in processing portion 2b of the image sensor in which a circuit is arranged.

Preferably, the cover member and the pressing member are united solidly.

In this case, it is possible to reduce the time required for assembly, because the cover member and the pressing member are united solidly.

The invention will now be further described, by way of example only, with reference to the accompanying drawings, in which:-
Fig. 1 is a sectional view of an image pickup device relating to Embodiment 1 of the invention.
Fig. 2 is a perspective view of an image pickup device relating to Embodiment 1 of the invention.
Fig. 3 is a perspective view of an optical member relating to Embodiment 1 of the invention.
Fig. 4 is a bottom face view of an optical member relating to Embodiment 1 of the invention.
Fig. 5 is a sectional view of a primary portion taken on line V - V in Fig. 1.
Fig. 6 is a top face view of an image sensor relating to Embodiment 1 of the invention.
Fig. 7 is a sectional view of an image pickup device relating to Embodiment 2 of the invention.
Fig. 8 is a perspective view of an optical member relating to Embodiment 2 of the invention.
Fig. 9 is a sectional view of a primary portion taken on line IX - IX in Fig. 7.
Fig. 10 is a sectional view of a primary portion taken on line X - X in Fig. 7.

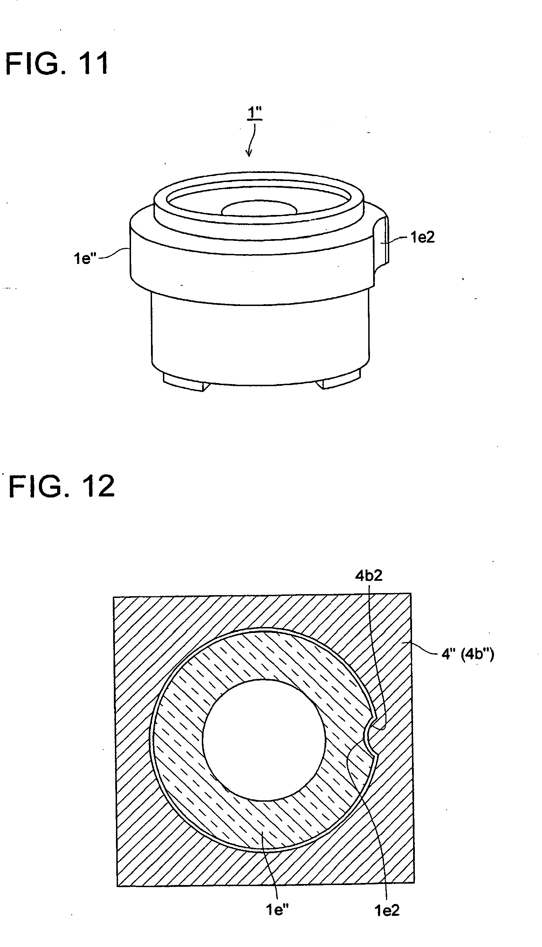

Fig. 11 is a perspective view showing a variation of an optical member relating to the invention.
Fig. 12 is a diagram for illustrating a rotation-preventing mechanism in the variation in Fig, 11.
Fig. 13(a) and Fig. 13(b) represent other Examples, wherein Fig. 13(a) is a schematic sectional view of an image pickup device composed of an optical member having therein two lenses and of a lens frame which engages with the optical member, and Fig. 13 (b) is a schematic sectional view of an image pickup device composed of an optical member having therein four lenses and of a lens frame which engages with the optical member.
Fig. 14 is a longitudinal section showing an example of an image pickup device in the conventional technology.

### (Embodiment 1)

An embodiment of the invention will be explained in detail as follows, referring to the drawings.

### (Embodiment 1)

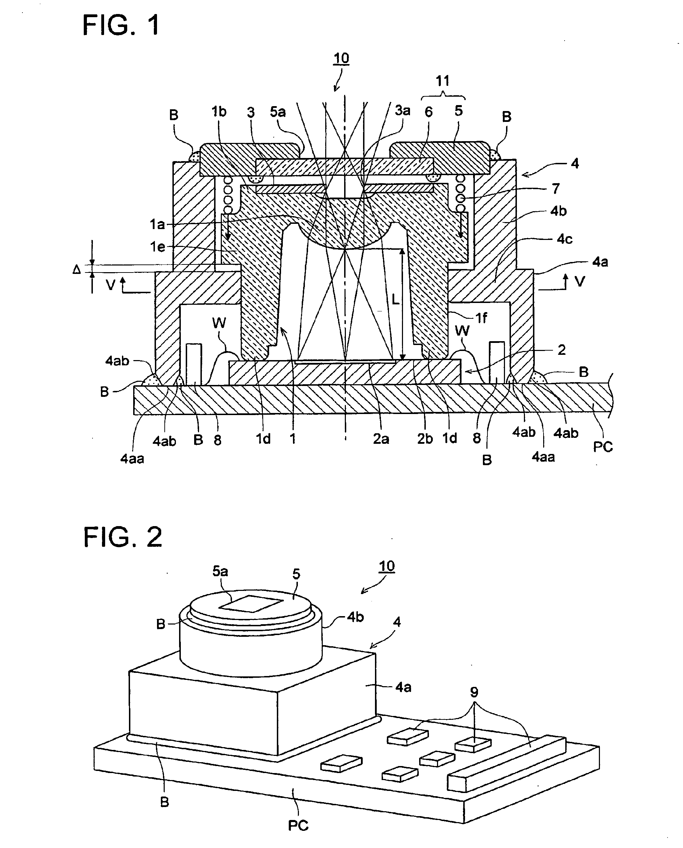

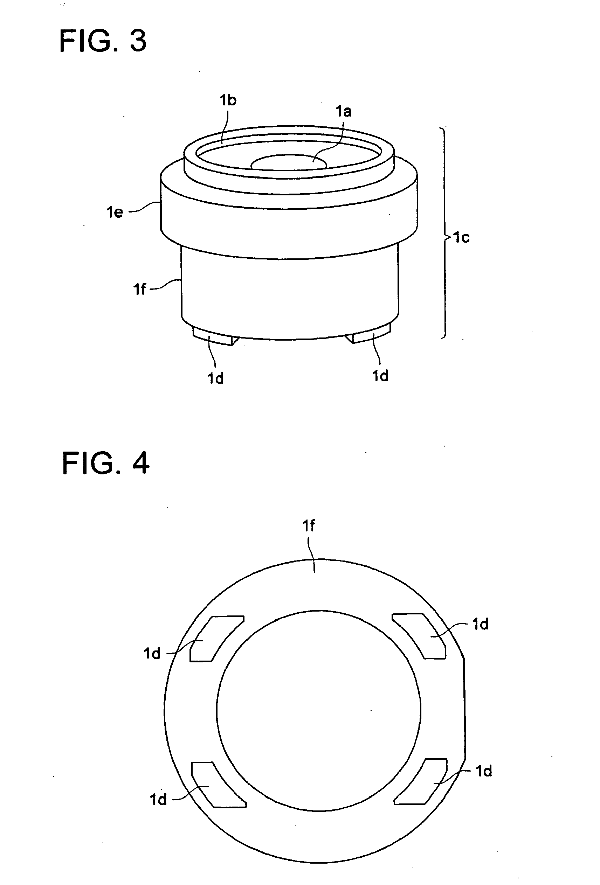

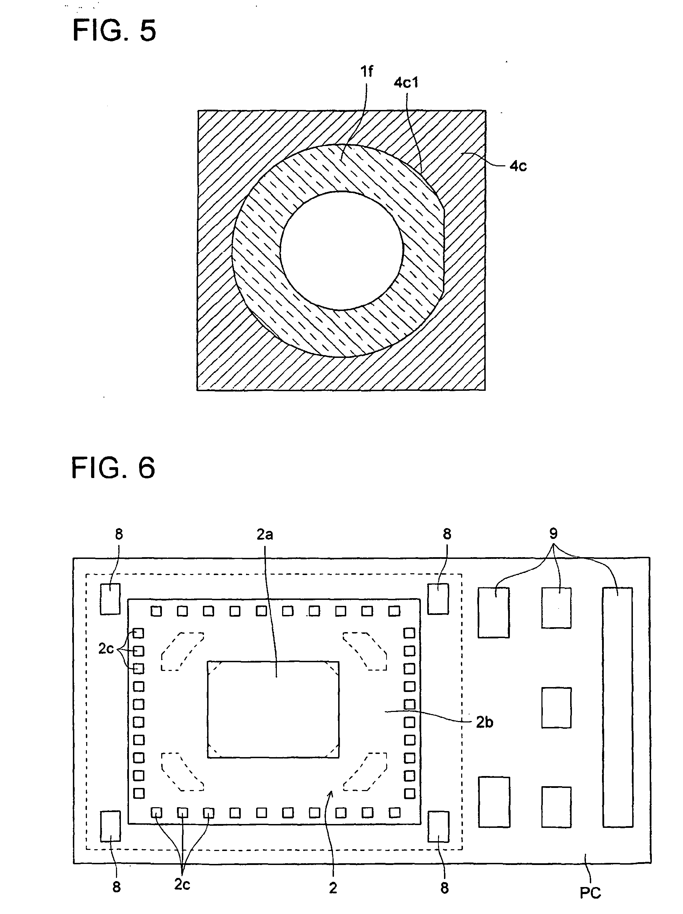

Fig. 1 is a sectional view of an image pickup device relating to the invention. Fig. 2 is a perspective view of the image pickup device in Fig. 1. Fig. 3 is a perspective view of optical member 1 and Fig. 4 is a bottom face view of an optical member. Fig. 5 is a sectional view taken on line V - V in Fig. 1. Fig. 6 is a top face view of an image sensor.

As shown in Figs. 1 and 2, image pickup device 10 is composed of base board PC, optical member 1, image sensor 2, diaphragm plate 3, lens frame 4, light shielding plate 5, filter 6, pressing member 7, positioning electric parts 8 and electric parts 9 arranged on the base board PC.

The optical member 1 is made of transparent plastic material, and as shown in Figs. 3 and 4, tubular leg portion 1c and convex-lens-formed lens portion 1a supported by the leg portion 1c are formed integrally in the optical member 1. The leg portion 1c has therein four contact portions 1d, upper leg portion 1e formed on a circumference on the upper end of the optical member 1, board-shaped top face portion 1b that closes the top end and lower leg portion 1f that is formed between the contact portions 1d and the upper leg portion 1e, and the lens portion 1a is formed at the center of the top face portion 1b.

The lower leg portion 1f is almost in a D-shaped form that is formed by an arc representing the interfitting part in terms of a shape and by a chord connecting both ends of the arc on a plane that is perpendicular to the optical axis.

Further, the diaphragm plate 3 which is made of material having a light-shielding property and has aperture 3a representing the first diaphragm that prescribes f-number of the convex lens portion 1a is fixed with adhesive agents B on a circumference of the lens portion 1a on the upper part of the top face portion 1b.

Outside the optical member 1, there is arranged lens frame 4 representing an outer frame member made of material having lighttightness.

On the lens frame 4, there are provided prismatic lower portion 4a and cylindrical upper portion 4b, as is apparent from Fig. 2. A lower end portion of the lower portion 4a is a place of adhesion for the lens frame 4 to be attached on the base board PC, and as shown in Fig. 1, an inner side surface and an outer side surface of the lens frame 4 are cut obliquely toward bottom surface 4aa at a prescribed angle, and thus, chamfered portions 4ab and 4ab each having a slanting surface are formed respectively inside and outside. When the lower portion 4a of the lens frame 4 is brought into contact with base board PC to be attached thereon, adhesive agents B are coated on the boundary between the base board PC and the bottom surface 4aa plus chamfered portions 4ab and 4ab to fix them.

On the circular inner surface of partition wall 4c of the lens frame 4, there is provided D-shaped groove 4c1 that corresponds to lower leg portion 1f of the optical member 1, as shown in Fig. 5, and the lower leg portion 1f is fitted in the D-shaped groove 4c1 closely. Therefore, it is possible to position the lens portion 1a to photoelectric converting portion 2a accurately in the direction perpendicular to an optical axis, only by positioning and arranging the base board PC and lens frame 4 by using, for example, an optical sensor provided in an automatic assembly machine so that the center of the circular aperture portion on the partition wall 4c and the center of photoelectric converting portion 2a of image sensor 2 described later may agree with each other.

On the other hand, light-shielding plate 5 is mounted on the top of the upper portion 4b of the lens frame 4 with adhesive agents B. The light-shielding plate 5 has, on its center, aperture 5a serving as a second diaphragm. Filter 6 made of material having infrared absorption characteristics is connected to the bottom side of the aperture 5a at the center of the light-shielding plate 5, with adhesive agents B.

The light-shielding plate 5 and the filter 6 constitute cover member 11. Since the base board PC, lens frame 4 and cover member 11 are joined closely each other as stated above, image pickup device 10 has a dust-proof and moistureproof structure.

In Fig. 1, pressing member 7 constituted by an elastic member such as, for example, a coil spring is arranged between the optical member 1 and the light-shielding plate 5. When the light-shielding plate 5 is mounted on the lens frame 4, the light-shielding plate 5 presses pressing member 7, and the pressing member 7 deforms elastically. This pressing member 7 presses the optical member 1 downward in Fig. 1 with prescribed pressing force, to urge the optical member 1 to image sensor 2. In this case, when a force toward the lower image sensor 2 from the light-shielding plate 5 is applied, pressing member 7 deforms elastically, and thus, buffer action to absorb the force is operated. Therefore, the force is not transmitted directly to the image sensor 2 and damage of the sensor 2 can be prevented.

In Fig. 6, image sensor 2 is composed, for example, of a CMOS (Complementary Metal Oxide Semiconductor) type image sensor. On the top face of the base board PC, there is attached rectangular lamina-shaped image sensor 2 with its bottom surface touching the top face of the base board PC. At the center of the top face of the image sensor 2, there are arranged pixels in a two-dimensional way so that photoelectric converting portion 2a having a light-receiving surface is formed. Processing portion 2b is formed outside the photoelectric converting portion 2a, and a plurality of pads 2c are arranged in the vicinity of an outer edge of the processing portion 2b. The pad 2c representing a terminal for connection is connected to the base board PC through wire W as shown in Fig. 1. The wire W is connected to a prescribed circuit on the base board PC.

Further, contact portion 1d of the optical member 1 is protruded from the bottom end of leg portion 1c to be in a shape shown in Fig. 4, and constitutes a part of the leg portion 1c. In the present embodiment, the optical member 1 is arranged under the condition wherein only contact portion 1d is in contact with processing portion 2b of the image sensor 2, as shown with broken lines on the image sensor 2 in Fig. 6. With respect to flatness on the surface, therefore, only the bottom surface of the contact portion 1d is required to be kept in a prescribed range. Further, the number of contact portions 1d is four, and a center of gravity of the optical member 1 comes to the center of the contact portions 1d. Therefore, it can be said that the contact portions 1d have positions and forms which make the optical axis of lens portion 1a to be perpendicular to a plane when the optical member 1 is placed individually on the plane. Accordingly, even when there is a slight clearance in the interfitting part where an outer circumferential surface of the optical member 1 is fitted in an inner circumferential surface of lens frame 4, the optical axis crosses photoelectric converting portion 2a of image sensor 2 at right angles when the contact portion 1d is brought into contact with processing portion 2b of image sensor 2, and images with less distortion can be obtained.

In this case, it is preferable that a load from contact portion 1d is not more than 500 g (not more than 1000 g/mm² in terms of a surface pressure), because there is a fear that image sensor 2 is damaged when this load (surface pressure) is exceeded. When blur of images caused by vibration is taken into consideration, however, it is preferable that a load from contact portion 1d is not less than 5 g. The load of this kind can be managed properly by selecting a wire diameter and the number of turns of a coil spring which is pressing member 7. The surface pressure in this case is one obtained by dividing a load applied on image sensor 2 through contact portion 1d of the optical member with an area of the surface which is in contact with contact portion 1d and is facing lens portion 1a.

In the present embodiment, gap Δ is formed between a bottom surface of upper leg portion 1e of the optical member 1 and partition wall 4c of lower portion 4a of lens frame 4, under the condition that the contact portion 1d is in contact with processing portion 2b of image sensor 2. Therefore, distance L between the lens portion 1a and photoelectric converting portion 2a of the image sensor 2 (namely, positioning in the direction of an optical axis) can be established accurately by the length of leg portion 1c. Though the number of contact portions 1d in the present embodiment is four, it may also be one, two or three. Further, the contact portion may also be a ring-shaped one that is formed along cylindrical leg portion 1c of the optical member 1, provided that interference with pad 2c can be avoided.

Further, since optical member 1 is made of plastic material, it is also possible to reduce a deviation of a focusing position caused by a change in refractive index of lens portion 1a in the case of temperature changes. Namely, in the plastic lens, when its temperature rises, refractive index of the lens is lowered, and its focusing position is changed to be farther from the lens. Since the leg portion 1c extends when temperature rises, on the other hand, there is an effect to reduce a deviation of a focusing position. Incidentally, the optical member 1 of the present embodiment is lighter than a glass lens when their volumes are the same each other, and is excellent in terms of shock absorption characteristics, because the optical member 1 is made of plastic material whose specific gravity is relatively low. Therefore, even when image pickup device 10 is dropped accidentally, damage of image sensor 2 can be restrained to the utmost, which is an advantage.

In the case of the structure wherein optical member 1 can rotate freely in lens frame 4, contact portion 1d interferes with pad 2c, therefore, there is provided a rotation-preventing mechanism which makes it possible to assemble while regulating a rotation of the optical member 1.

To be concrete, the rotation-preventing mechanism is composed of lower leg portion 1f which is almost D-shaped representing an interfitting part that is fitted in the lens frame and of D-shaped groove 4c1 that is an interfitting part in partition wall 4c of lens frame 4, as shown in Figs. 4 and 5.

Namely, when the lower portion 1f of the optical member 1 is inserted in the D-shaped groove 4c1, the optical member 1 is regulated in terms of its rotation around an optical axis, and positions on two axes in the horizontal plane can be determined.

Positioning electric parts 8 are represented, for example, by a capacitor, a resistance and a diode, and they are arranged to be close to lens frame 4 between image sensor 2 on base board PC and lens frame 4 in Fig. 1. Further, a height from the PC base board to a top end portion of the positioning electric parts 8 is greater than that from the PC base board to a top end portion of the image sensor 2. In Fig. 6, four positioning electric parts 8 are arranged to surround a square inside the adherence part (a portion enclosed with dotted lines to be a square in Fig. 6) of the lens frame 4. Therefore, the positioning electric parts 8 serve as an index for positioning the lens frame 4 when adhering the lens frame 4 on the base board PC. Further, the top end of the positioning electric parts 8 is higher than that of image sensor 2, which prevents that the lens frame 4 comes in contact with the image sensor 2 to damage a wire and others.

Incidentally, the positioning electric parts 8 have only to be electric parts which are required by image pickup device 10, without being limited, for example, to a capacitor, a resistance and a diode.

Electric parts 9 are those necessary for operating image pickup device 10, in addition to the positioning electric parts 8.

Operations of the present embodiment will be explained as follows.

Lens portion 1a of optical member 1 forms an image of an object on photoelectric converting portion 2a of image sensor 2. The image sensor 2 can convert electric signals corresponding to an amount of light received into image signals to output through pad 2c and wire W.

Further, in the present embodiment, it is possible to make adjustment about a focusing position of lens portion 1a to be unnecessary in the course of assembling, by controlling dimensional accuracy of leg portion 1c of optical member 1 (including contact portion 1d), namely, by controlling accuracy of the aforesaid distance L, because optical member 1 is mounted on processing portion 2b of image sensor 2 without being mounted on base board PC. Incidentally, in order to make adjustment about a focusing position to be unnecessary, it is necessary to limit a deviation between photoelectric converting portion 2a of image sensor 2 and an image point of lens portion 1a of the optical member 1 to about ± F x 2P (F: f-number of a lens portion, P: pixel pitch of image sensor) in terms of air-converted length.

In the present embodiment, positions of lens portion 1a and photoelectric converting portion 2a of image sensor 2 in the direction of an optical axis can be determined by contact portion 1d of leg portion 1c of optical member 1 that comes in contact with processing portion 2b of image sensor 2. Further, when lens frame 4 is mounted on base board PC with photoelectric converting portion 2a of image sensor 2 serving as a standard for positioning, positions of lens portion 1a and photoelectric converting portion 2a of image sensor 2 in the direction perpendicular to an optical axis are determined, which makes it possible to attain high positioning accuracy at low cost.

In addition, the lens frame 4 is adhered to base board PC with adhesive agents, and together with other two adhered portions, the outside of image pickup device 10 is kept to be in the state sealed hermetically so that foreign substances may not invade, thus, bad influences of foreign substances on the photoelectric converting portion 2a of image sensor 2 can be eliminated. It is preferable that adhesive agents used for the foregoing have hygroscopic property. Due to this, it is possible to absorb moisture inside the lens frame 4, and thereby to prevent deterioration on the surface of the image sensor 2 and pad 2c caused by moisture.

Since there is provided pressing member 7 that presses a top face on the step section of upper leg portion 1e of optical member 1 in the direction of an optical axis with prescribed elastic force, it is possible to press leg portion 1c against processing portion 2b of image sensor 2 with appropriate pressing force (the force corresponding to a load ranging from 5 g to 500 g) by using elastic force of the pressing member 7. Therefore, even when deformation such as a warp of the part is caused by aging changes despite easy positioning of optical member 1 and image sensor 2 in the direction of an optical axis, it is possible to urge the optical member 1 against image sensor 2 with stable elastic force, and thereby to control backlash of the optical member 1 in the case of occurrence of vibration, and further to prevent that excessive stress is caused on processing portion 2b of image sensor 2 in which a circuit is arranged, when a shock is caused. Further, when large forces such as impact forces are applied in the direction of an optical axis of lens frame 4, these forces are not transmitted directly to the image sensor 2 though they are transmitted to base board PC, which is preferable from the viewpoint of protection of the image sensor 2. Incidentally, as pressing member 7, an elastic member such as, for example, a coil spring is used. In addition, urethane or sponge may also be used, but an elastic material which is of resin or metal that can exhibit stable elastic force for a long time is preferable.

It is also possible to employ the structure wherein filter 6 representing a cover member is structured by an elastic member and light-shielding plate 5 presses the filter 6 to press optical member 1, and further to employ the structure wherein light-shielding plate 5 representing cover member 11 is structured by an elastic member and the light-shielding plate 5 presses directly the optical member 1. By uniting the cover member and the pressing member 7 solidly as mentioned above, assembling man-hour for the image pickup device can be reduced.

Since the cover member 11 composed of light-shielding plate 5 and filter 6 is arranged to be closer to an object than from lens portion 1a, the lens portion 1a is not exposed to the outside to be protected, and sticking of foreign substances to the lens surface is prevented. Further, filter 6 is made of substances having infrared absorption characteristics, and it is not necessary to provide an infrared blocking filter separately, and thereby the number of parts can be reduced, which is preferable. In place of giving infrared blocking characteristics to filter 6, it is considered to form optical member 1 itself with material having infrared absorption characteristics or to coat a film having infrared blocking characteristics on the surface of lens portion 1a.

Further, in the course of assembling, optical member 1 can be inserted in lens frame 4 from the object side, under the condition that light-shielding plate 5 is taken out of lens frame 4, and then, the light-shielding plate 5 can be mounted on the lens frame 4. Due to the structure of this kind, incorporation of the optical member 1 is improved, and automatic assembly can be carried out easily. If an air-escape vent is formed on either one of lower portions 4a of lens frame 4 in this case, it is possible to conduct assembling easily even if the gap between the lens frame 4 and the optical member 1 is small. However, it is preferable to fill this air-escape vent with fillers after assembling so that invasion of foreign substances from the outside and surface deterioration of image sensor 2 and pad 2c may be controlled. Further, it is preferable that the fillers have light-shielding properties so that they may restrain light leakage. Incidentally, it is possible to insert the optical member 1 after the lens frame 4 has been glued on the base board PC, or it is possible to mount the optical member 1 on the lens frame 4 first and then, to glue the unit of the optical member 1 and the lens frame 4 on the base board PC, by which the degree of freedom of the process can be secured. In the case of the latter assembly, partition wall 4c of the lens frame 4 can also serve as the function to prevent falling out of the optical member 1.

Further, since the leg portion 1c of the optical member 1 is arranged in the vicinity of photoelectric converting portion 2a of image sensor 2, reflecting on the leg portion 1c and entering the photoelectric converting portion 2a by a light flux that is not contributing to image forming are feared to be causes for occurrence of ghost and flare. To prevent this, it is effective to arrange the second diaphragm (aperture 5a) that regulates peripheral light fluxes to be closer to an object than from the first diaphragm (aperture 3a) that prescribes f-number of lens portion 1a, and to reduce incidence of unwanted light. Incidentally, further effects may be obtained by making the aperture 5a of the second diaphragm to be a rectangle, because field angles are different depending on the directions of a shorter side, a longer side and a diagonal line of photoelectric converting portion 2a of image sensor 2. In addition, though this function is owned by aperture 5a of light-shielding plate 5 in the present embodiment, it is also possible to form a diaphragm by coating a film having light-shielding property on an area other than a necessary aperture on the side of filter 6 closer to an object. Further, for the same reason, it is preferable to apply processing to prevent internal reflection on at least a part of leg portion 1c. The processing to prevent internal reflection includes, for example, forming the surface provided with microscopic unevenness to diverge light flux that does not contribute to image forming, and applying of reflection-preventing coating or of coating having low reflection characteristics.

Further, since diaphragm plate 3 equipped with aperture 3a is provided on the plane of incidence side of lens portion 1a, it is possible to make a light flux entering photoelectric converting portion 2a of image sensor 2 to enter at an angle close to verticality, namely, to realize a structure close to a telecentric type, and thereby to obtain images of high image quality. Further, by making a form of lens portion 1a to be a form of a positive lens whose surface having sharp curvature faces the object side, a distance between the first diaphragm (aperture 3a) and a principal point of the lens portion 1a can be made great, resulting in a preferable structure that is closer to a telecentric type.

In image pickup device 10 of the first embodiment explained above, it is possible to adjust a focusing position in the direction of an optical axis of the lens portion, and to make it unnecessary to adjust a focusing position in the direction of an optical axis of lens portion 1a, in the course of assembling and after assembling, by assembling image pickup device 1 under the condition of stable dimensional accuracy of each constituent member, because optical member 1 is urged by pressing member 7 with prescribed pressing force to be brought into contact with image sensor 2 directly. Further, since the interfitting part where lower leg portion 1f is fitted in lens frame 4 is almost in a D-shaped form that is formed by an arc representing the interfitting part and by a chord connecting both ends of the arc on a plane that is perpendicular to the optical axis, the lens portion 1a is positioned in the rotational direction, and rotation of the lens portion 1a can be prevented.

Therefore, the lens portion 1a of the optical member 1 can be positioned easily and accurately in the three directions of three axes.

Incidentally, the interfitting part may be provided on upper leg portion 1f. Namely, the upper leg portion 1f may be made to be in a D-shaped form, and a D-shaped groove corresponding to the D-shaped form may be provided on the upper portion 1b of lens frame 4 so that the upper leg portion 1f is fitted in the D-shaped groove.

### (Embodiment 2)

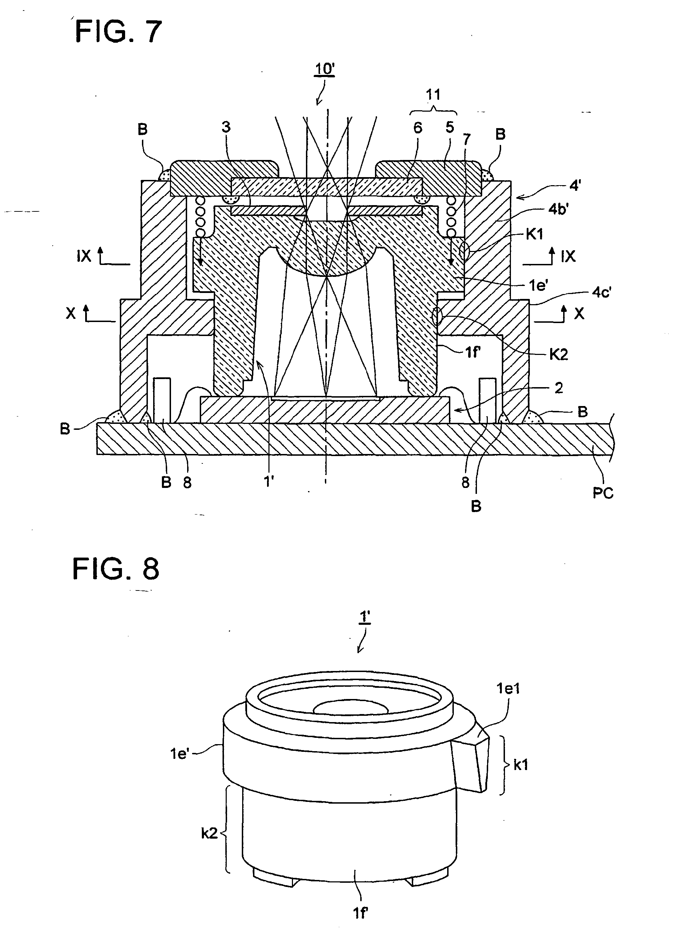

Fig. 7 is a sectional view of image pickup device 10' relating to the present embodiment. In the second embodiment, only difference from the first embodiment stated above is a structure of the rotation-preventing mechanism for the optical member, and other structures which are the same as those in the first embodiment are given the same symbols and explanation thereof will be omitted.

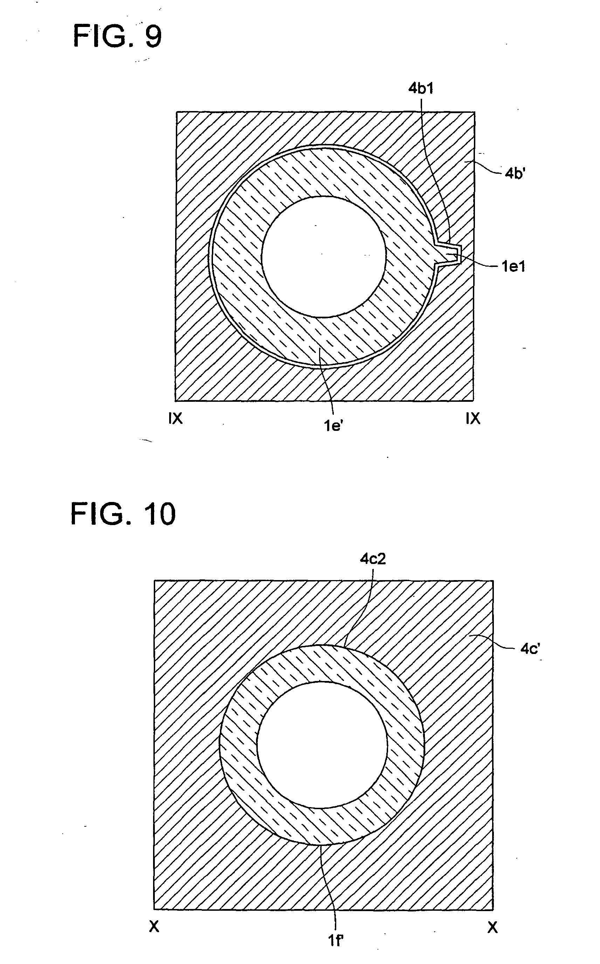

In Fig. 7, optical member 1' and lens frame 4', for example, are fitted in interfitting part K1 and brought into contact with contact part K2 as shown in Figs. 8 and 9. The interfitting part K1 is provided at the position that is closer to lens portion 1a than from contact part K2, and its outside diameter is greater than that of the contact part K2 on the section perpendicular to the optical axis.

Upper leg portion 1e' corresponding to the interfitting part K1 on the optical member 1' side is formed to be almost a circular form on the plane perpendicular to the optical axis as shown in Figs. 8 and 9, and projection portion 1e1 that is protruded horizontally is formed on a part of the upper leg portion 1e'.

This projection portion 1e1 has a form that is tapered downward to be narrower, and this is formed by leaving a part of a gate (not illustrated) when gate-cutting, for example, optical member 1' formed by a mold.

On the other hand, on the upper portion 4b' of lens frame 4' in interfitting part K1, there is provided tapered groove 4b1 corresponding to the form of projection portion 1e1 of the upper leg portion 1e' so that the projection portion 1e1 may be fitted in the tapered groove 4b1.

In the image pickup device 10' of the second embodiment, therefore, a rotation-preventing mechanism for the optical member 1' is formed by projection portion 1e1 of the optical member 1' and tapered groove 4b1 of lens frame 4'.

Lower leg portion 1f' in contact part K2 on the optical member 1' side is formed to be almost in a circular form on a section perpendicular to the optical axis as shown in Fig. 8 and Fig. 10, while, on partition wall 4c' of lens frame 4' in contact part K2, there is provided mostly circular groove 4c2 corresponding to a mostly circular form of lower leg portion 1f'.

In image pickup device 10' of the second embodiment explained above, it is possible to adjust a focusing position in the direction of an optical axis of the lens portion 1a, and to make it unnecessary to adjust a focusing position in the direction of an optical axis of lens portion 1a, in the course of assembling and after assembling, by assembling image pickup device 10' under the condition of stable dimensional accuracy of each constituent member, because optical member 1' is urged by pressing member 7 with prescribed pressing force to be brought into contact with image sensor 2 directly. Further, the lens portion 1a is positioned in the rotational direction, and rotation of the lens portion 1a can be prevented by a rotation-preventing mechanism provided on interfitting part K1 where upper leg portion 1e' is fitted in lens frame 4.

Therefore, the lens portion 1a can be positioned easily and accurately in the three directions of three axes.

Since optical member 1' and lens frame 4' are brought into contact with each other on contact part K2, and then, fitted each other at interfitting part K1, thus, the optical member 1' can be fixed on the lens frame 4' more firmly.

When inserting the optical member 1' in the lens frame 4' from the upper side, lower portion 1f' is brought into contact with mostly circular groove 4c2 of the lens frame 4' in the contact part K2 first, and then, projection portion 1e1 of upper leg portion 1e' is fitted in tapered groove 4b1 of lens frame 4 in interfitting part K1. Therefore, under the condition of touching the contact part K2, there still is a degree of freedom in the direction of rotation around the optical axis, and therefore, fitting can be conducted at interfitting part K1 while turning in the rotational direction, which makes assembly work easy.

Since the outside diameter of interfitting part K1 is greater than that of contact part K2, even when lens frame 4' is glued on base board PC after optical member 1' is fitted in lens frame 4', the optical member 1' does not fall out and a degree of freedom for the process can be secured.

Further, projection portion 1e1 has a form that is tapered downward to be narrower, and tapered groove 4c1 has a form corresponding to the taper of the projection portion 1e1, therefore, accuracy in positioning for rotation prevention can be improved.

Incidentally, in the interfitting part K1 in the second embodiment stated above, projection portion 1e1 is provided on upper leg portion 1e' of optical member 1', and tapered groove 4b1 is provided on upper portion 4b' of lens frame 4'. However, it is also possible to arrange so that groove portion 1e2 is provided on upper leg portion 1e'' of optical member 1'' and projection portion 4b2 is provided on upper portion 4b'' of lens frame 4''.

Further, a form of upper leg portion 1e' in interfitting part K1 may be made to be a D-shaped form on the section in the horizontal direction.

Though the invention has been explained above, referring to the embodiment, the invention should not be construed to be limited to the aforementioned embodiment, and it is naturally possible to modify or improve the invention. For example, though contact portion 1d of optical member 1 is in contact with the top surface of image sensor 2 in the present embodiment, the contact portion 1d may also be in contact with base board PC or in contact with both image sensor 2 and base board PC.

The rotation-preventing mechanism is not limited to that illustrated in the embodiment, and an interfitting part, for example, may also be in an I-shaped form.

Further, in the present embodiment, image sensor 2 is of the structure of a bare-chip. However, it is also considered that the image sensor 2 is made to be of the durable structure by applying a protective member such as glass or film on the top surface or on the bottom surface of the image sensor. Further, base board PC may also be a flexible one without being limited to a hard one.

An image pickup device of the invention is considered to be capable of being incorporated in various objects such as a cellphone, a personal computer, PDA, AV equipment, a television set and a household appliance.

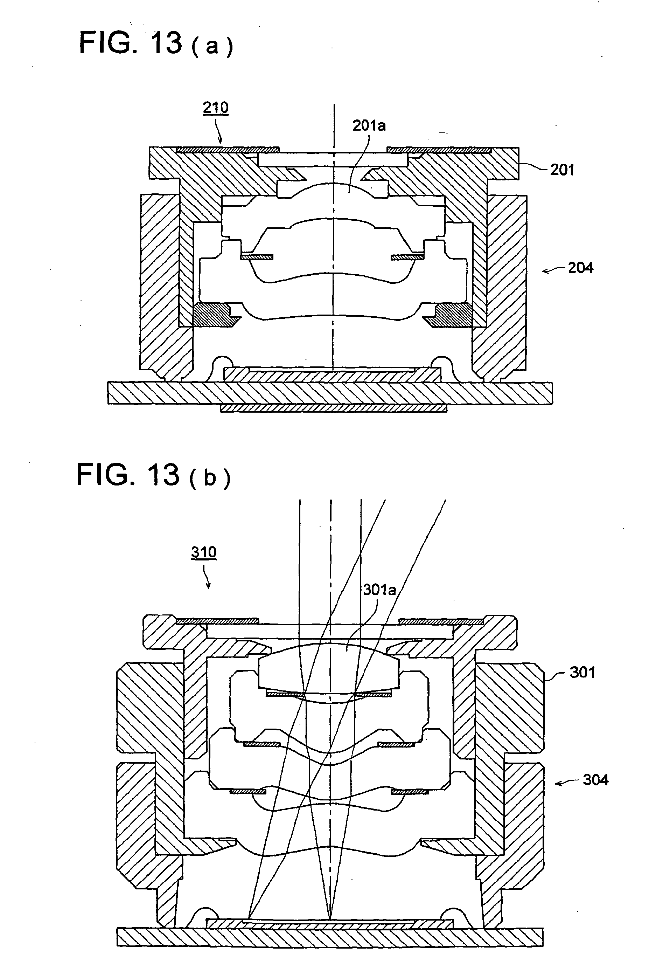

Fig. 13(a) represents another Example showing a schematic sectional view of image pickup device 210 composed of optical member 201 whose lens portion 201a has two lenses and of lens frame 204 which engages with the optical member 201. In the same way, Fig. 13(b) represents still another Example showing a schematic sectional view of image pickup device 310 composed of optical member 301 whose lens portion 301a has four lenses and of lens frame 304 which engages with the optical member 301.

Hereupon, when a glass mold lens is used for the first lens which is closest to an object in each of Figs. 13 (a) and 13 (b), it is necessary to establish a temperature for press working in mold pressing to be high in general, if the glass has its high glass transition point (Tg), which makes a metal mold for molding to be subject to wear and damage. As a result, the number of times for replacement of a metal mold for molding and the number of times of maintenances are increased, resulting in cost increase. When using a glass mold lens, therefore, it is preferable to use glass materials whose glass transition point is 400°C or less.

It is preferable, from the viewpoint of dispersion and refractive index, to use a glass lens in an optical system for photographing, but it is necessary, in the optical system for photographing, to reduce the number of lenses by employing an aspherical lens, because white light is a prior condition. In this case, the aspherical lens is naturally manufactured by transferring the surface form through press molding by means of die-stamping, because it is impossible to manufacture through a lens smoothing and polishing method.

In this case, glass materials are heated to be subjected to die-stamping as a matter of course, and if a temperature in that case is high (in other words, the melting point is high, glass transition point is high), a die to be used for pressing is deteriorated quickly by heat (not durable for a large number of shots).

Further, when making a die, it is necessary to select a material for the die that is proof against high temperature, resulting in less choices for the materials.

In addition, in the case of working of die-stamping, a glass material is heated up to high temperature, and then, stamping is conducted, and after that, cooling is required, which makes a cycle time to be long.

If a glass material having low melting point is used, on the contrary to the foregoing, the problems stated above are solved. Namely, choices for selection of a material for the die are broadened, a die life is prolonged and a cycle time in the actual working can be shortened.

In the invention, it is possible to adjust a focusing position in the direction of an optical axis of the lens portion, and to make it unnecessary to adjust a focusing position in the direction of an optical axis of lens portion, in the course of assembling and after assembling, by assembling image pickup device under the condition of stable dimensional accuracy of each constituent member, because an optical member is urged by a pressing member with prescribed pressing force to be brought into contact directly with a base board or an image sensor. Further, a lens portion is positioned in the rotational direction by a rotation-preventing mechanism provided on interfitting part where the optical member is fitted in an outer frame member, and rotation of the lens portion is prevented.

Therefore, the lens can be positioned easily and accurately in the three directions of three axes.

Since the optical member and the outer frame member are brought into contact with each other on the contact part, and then, the optical member is fitted in the outer frame member at the interfitting part while keeping the state of the contact in the invention, thus, the optical member can be fitted more firmly in the outer frame member, and the lens can be positioned accurately in the three directions of three axes.

In addition, the interfitting part is positioned so that a distance from it to the lens portion is shorter than a distance from the lens portion to the contact part, therefore, when the optical member is inserted in the outer frame member from the upper portion for assembling, the contact portion is brought into contact, and then, the interfitting part is fitted. Therefore, under the condition that the outer frame member is inserted in the contact part, there still is a degree of freedom in the rotational direction, which makes assembling work easy.

Further, even when the outer frame member is fixed on the base board after the optical member is fitted in the outer frame member, the optical member does not fall out, because an outside diameter of the interfitting part is greater than that of the contact part.

Since prescribed pressing force is applied on the pressing member by a cover member, it is possible to urge the optical member against the image sensor with stable elastic force even when deformation such as a warp is caused on parts by an aging change, despite that positioning of the optical member and the image sensor in the direction of an optical axis is easy, and it is possible to control backlash of the optical member in the case where vibration is caused accordingly, and when an impact is given as well, it is prevented that excessive stress builds up in processing portion of the image sensor in which a circuit is arranged.

Further, assembling man-hour can be reduced because the cover member and the pressing member are united solidly.

## Claims

1. An image pickup device (10) comprising:
(a) a base board (PC) provided with an image sensor (2) ;
(b) an outer frame member (4) fixed on the base board (PC) for shielding at least the image sensor (2);
(c) an optical member (1) having a lens portion (1a) that forms an image of an object on a light-receiving surface (2a) of the image sensor, an outer form portion (1c) that supports the lens portion (1a) and a contact portion (1d), which is integrally formed with the outer form portion (1c) and is in contact with the image sensor (2); and **characterised by**:
(d) a pressingmember (7) for urging the optical member (1) in a direction of an optical axis of the lens portion (1a) with prescribed pressing force, to bring the contact portion (1d) into contact with the image sensor (2),
wherein an interfitting part of an inner circumferential surface of the outer frame member (4) and an interfitting part of an outer circumferential surface of the outer form portion (1c) of the optical member constitute a rotation-preventing mechanism for preventing rotation of the optical member around the optical axis by engaging the interfitting part of the inner circumferential surface of the outer frame member with the interfitting part of the outer circumferential surface of the outer form portion (1c) of the optical member (1).

2. The image pickup device of claim 1,
wherein the interfitting part (K1) of the outer circumferential surface of the outer form portion (1c) has a D-shaped form that is formed by an arc and a chord connecting both ends of the arc on a plane that is perpendicular to the optical axis, and the interfitting part of the inner circumferential surface of the outer frame member (4) has a D-shaped groove corresponding to the D-shaped form.

3. The image pickup device of claim 2, wherein a contact part of the inner circumferential surface of the outer frame member (4) and a contact portion of the outer circumferential surface of the outer form portion (1c) are in contact with each other to be capable of rotating around the optical axis, and
wherein the contact part of the inner circumferential surface of the outer frame member (4) is provided at a position other than the interfitting part of the inner circumferential surface of the outer frame member (4) and is provided closer to the lens portion (1a) than the interfitting part of the inner circumferential surface of the outer frame member (4), while the contact part of the outer circumferential surface of the outer form portion (1c) is provided at a position other than the interfitting part of the outer circumferential surface of the outer form portion (1c) and is provided closer to the lens portion (1a) than the interfitting part of the outer circumferential surface of the outer form portion (1c).

4. The image pick up device of claim 3, wherein an outside diameter of the interfitting part of the outer circumferential surface of the outer form portion (1c) is greater than the outside diameter of the contact part of the outer circumferential surface of the outer form portion (1c).

5. The image pickup device of claim 1, wherein the interfitting part (K1) of the outer circumferential surface of the outer form portion (1e') has a projection portion (1e1) that is provided on the outer circumferential surface of the outer form portion (1e') and is projected toward the outer frame member (4), and the interfitting part of the inner circumferential surface of the outer frame member (4') has a groove portion (4b1) that is provided on the inner circumferential surface of the outer frame member (4') and is engaged with the projection portion (1e1).

6. The image pickup device of claim 1, wherein the inner circumferential surface of the outer frame member (4") has a projection portion (4b2) that is projected toward the outer form portion (1e") of the optical member (1"), and the interfitting part (K1) of the outer circumferential surface of the outer form portion (1e") has a groove portion (1e2) that is provided on the outer circumferential surface of the outer form portion (1e") and is engaged with the projection portion (1e2).

7. The image pickup device of claim 5, wherein the projection portion (1e1) has a narrow form that is tapered downward, and the groove portion (4b1) has a shape corresponding to the narrow form of the projection portion (1e1).

8. The image pick up device of claim 1, further comprising a cover member (5) that is attached on the outer frame member (4) and is fixed by applying prescribed pressing force on the pressing member (7).

9. The image pickup device of claim 8, wherein the cover member (5) and the pressing member (7) are united solidly.

## Patentansprüche

1. Bildaufnahmeeinheit (10), mit:
(a) einem Grundträger (PC), der mit einem Bildsensor (2) versehen ist,
(b) einem äußeren Rahmenelement (4), das an dem Grundträger (PC) befestigt ist, zum Abschirmen zumindest des Bildsensors (2),
(c) einem optischen Element (1) mit einem Linsenabschnitt (1a), das ein Bild eines Gegenstands auf einer Lichtaufnahmefläche (2a) des Bildsensors erzeugt, einem äußeren Formabschnitt (1c), der den Linsenabschnitt (1a) trägt, und einem Kontaktabschnitt (1d), der integral mit dem Außenformabschnitt (1c) ausgebildet ist und sich in Kontakt mit dem Bildsensor (2) befindet, **gekennzeichnet durch**:
(d) ein Druckelement (7) zum Vorbelasten des optischen Elements (1) in einer Richtung einer optischen Achse des Linsenabschnitts (1a) mit vorgegebener Druckkraft, um den Kontaktabschnitt (1d) in Kontakt mit dem Bildsensor (2) zu bringen,
wobei ein Passteil einer Innenumfangsfläche des äußeren Rahmenelements (4) und ein Passteil einer Außenumfangsfläche des äußeren Formabschnitts (1c) des optischen Elements einen Drehverhinderungsmechanismus zum Verhindern einer Drehung des optischen Elements um die optische Achse **durch** Eingriff des Passteils der Innenumfangsfläche des äußeren Rahmenelements mit dem Passteil der Außenumfangsfläche des äußeren Formabschnitts (1c) des optischen Elements (1) bilden.

2. Bildaufnahmeeinheit nach Anspruch 1, wobei der Passteil (K1) der Außenumfangsfläche des äußeren Formabschnitts (1c) eine D-förmige Form aufweist, die durch einen Bogen und eine Bogensehne gebildet ist, welche beide Enden des Bogens auf einer Ebene verbindet, die senkrecht zu der optischen Achse ist, und der Passteil der Innenumfangsfläche des äußeren Rahmenelements (4) eine D-förmige Nut bzw. Rille aufweist, die der D-Form entspricht.

3. Bildaufnahmeeinheit nach Anspruch 2, wobei ein Kontaktteil der Innenumfangsfläche des äußeren Rahmenelements (4) und ein Kontaktabschnitt der Außenumfangsfläche des äußeren Formabschnitts (1c) miteinander in Kontakt stehen, um sich um die optische Achse drehen zu können, und
wobei der Kontaktteil der Innenumfangsfläche des äußeren Rahmenelements (4) an einer anderen Position vorgesehen ist als der Passteil der Innenumfangsfläche des äußeren Rahmenelements (4), und näher an dem Linsenabschnitt (1a) vorgesehen ist als der Passteil der Innenumfangsfläche des äußeren Rahmenelements (4), während der Kontaktteil der Außenumfangsfläche des äußeren Formabschnitts (1c) an einer anderen Position vorgesehen ist als der Passteil der Außenumfangsfläche des äußeren Formabschnitts (1c), und näher an dem Linsenabschnitt (1a) vorgesehen ist als der Passteil der Außenumfangsfläche des äußeren Formabschnitts (1c).

4. Bildaufnahmeeinheit nach Anspruch 3, wobei ein Außendurchmesser des Passteils der Außenumfangsfläche des äußeren Formabschnitts (1c) größer ist als der Außendurchmesser des Kontaktabschnitts der Außenumfangsfläche des äußeren Formabschnitts (1c).

5. Bildaufnahmeeinheit nach Anspruch 1, wobei der Passteil (K1) der Außenumfangsfläche des äußeren Formabschnitts (1e') einen Vorsprungsabschnitt (1e1) aufweist, der an der Außenumfangsfläche des äußeren Formabschnitts (1e') vorgesehen ist und zu dem äußeren Rahmenelement (4) vorsteht, und der Passteil der Innenumfangsfläche des äußeren Rahmenelements (4') einen Nut- bzw. Rillenabschnitt (4b1) aufweist, der an der Innenumfangsfläche des äußeren Rahmenelements (4') vorgesehen ist und mit dem Vorsprungsabschnitt (1e1) in Eingriff steht.

6. Bildaufnahmeeinheit nach Anspruch 1, wobei die Innenumfangsfläche des äußeren Rahmenelements (4") einen Vorsprungsabschnitt (4b2) aufweist, der zu dem äußeren Formabschnitt (1e") des optischen Elements (1") vorsteht, und der Passteil (K1) der Außenumfangsfläche des äußeren Formabschnitts (1e") einen Nut- bzw. Rillenabschnitt (le2) aufweist, der an der Außenumfangsfläche des äußeren Formabschnitts (1e") vorgesehen ist und mit dem Vorsprungsabschnitt (le2) in Eingriff steht.

7. Bildaufnahmeeinheit nach Anspruch 5, wobei der Vorsprungsabschnitt (1e1) eine schmale, sich nach unten verjüngende Form aufweist, und der Nutenabschnitt (4b1) eine Form aufweist, die der schmalen Form des Vorsprungsabschnitts (1e1) entspricht.

8. Bildaufnahmeeinheit nach Anspruch 1, ferner mit einem Abdeckelement (5), das an dem äußeren Rahmenelement (4) angebracht ist und durch Aufbringen einer vorgegebenen Druckkraft auf das Druckelement (7) befestigt ist bzw. wird.

9. Bildaufnahmeeinheit nach Anspruch 8, wobei das Abdeckelement (5) und das Druckelement (7) fest miteinander verbunden sind.

## Revendications

1. Dispositif de prise de vues (10) comprenant :
(a) une plaque (PC) pourvue d'un capteur d'image (2) ;
(b) un élément de cadre externe (4) fixé sur la plaque (PC) pour protéger au moins le capteur d'image (2) ;
(c) un élément optique (1) ayant une partie de lentille (1a) qui forme une image d'un objet sur une surface de réception de lumière (2a) du capteur d'image, une partie de forme externe (1c) qui supporte la partie de lentille (1a) et une partie de contact (1d), qui est formée d'un seul tenant avec la partie de forme externe (1c) et est en contact avec le capteur d'image (2) ; et
**caractérisé par** :
(d) un élément presseur (7) pour pousser l'élément optique (1) dans une direction d'un axe optique de la partie de lentille (1a) avec une force de pression déterminée, pour amener la partie de contact (1d) en contact avec le capteur d'image (2),
dans lequel une partie d'interconnexion d'une surface circonférentielle externe de l'élément de cadre externe (4) et une partie d'interconnexion d'une surface circonférentielle externe de la partie de forme externe (1c) de l'élément optique constituent un mécanisme anti-rotation pour empêcher la rotation de l'élément optique autour de l'axe optique en mettant en prise la partie d'interconnexion de la surface circonférentielle interne de l'élément de cadre externe avec la partie d'interconnexion de la surface circonférentielle externe de la partie de forme externe (1c) de l'élément optique (1).

2. Dispositif de prise de vues selon la revendication 1,
dans lequel la partie d'interconnexion (K1) de la surface circonférentielle externe de la partie de forme externe (1c) a une forme en D qui est constituée par un arc et une corde reliant les deux extrémités de l'arc sur un plan qui est perpendiculaire à l'axe optique, et la partie d'interconnexion de la surface circonférentielle interne de l'élément de cadre externe (4) a une rainure en D correspondant à la forme en D.

3. Dispositif de prise de vues selon la revendication 2,
dans lequel une partie de contact de la surface circonférentielle interne de l'élément de cadre externe (4) et une partie de contact de la surface circonférentielle externe de la partie de forme externe (1c) sont en contact l'une avec l'autre pour pouvoir tourner autour de l'axe optique, et
dans lequel la partie de contact de la surface circonférentielle interne de l'élément de cadre externe (4) est prévue à une position autre que la partie d'interconnexion de la surface circonférentielle interne de l'élément de cadre externe (4) et est prévue plus près de la partie de lentille (1a) que la partie d'interconnexion de la surface circonférentielle interne de l'élément de cadre externe (4), tandis que la partie de contact de la surface circonférentielle externe de la partie de forme externe (1c) est prévue à une position autre que la partie d'interconnexion de la surface circonférentielle externe de la partie de forme externe (1c) et est prévue plus près de la partie de lentille (1a) que la partie d'interconnexion de la surface circonférentielle externe de la partie de forme externe (1c).

4. Dispositif de prise de vues selon la revendication 3, dans lequel le diamètre extérieur de la partie d'interconnexion de la surface circonférentielle externe de la partie de forme externe (1c) est plus grand que le diamètre extérieur de la partie de contact de la surface circonférentielle externe de la partie de forme externe (1c).

5. Dispositif de prise de vues selon la revendication 1, dans lequel la partie d'interconnexion (K1) de la surface circonférentielle externe de la partie de forme externe (1e1) a une partie formant saillie (1e1) qui est prévue sur la surface circonférentielle externe de la partie de forme externe (1e') et fait saillie vers l'élément de cadre externe (4), et la partie d'interconnexion de la surface circonférentielle interne de l'élément de cadre externe (4') a une partie formant rainure (4b1) qui est prévue sur la surface circonférentielle interne de l'élément de cadre externe (4') et est en prise avec la partie formant saillie (1e1).

6. Dispositif de prise de vues selon la revendication 1, dans lequel la surface circonférentielle interne de l'élément de cadre externe (4") a une partie formant saillie (4b2) qui fait saillie vers la partie de forme externe (1e") de l'élément optique (1" ), et la partie d'interconnexion (K1) de la surface circonférentielle externe de la partie de forme externe (1e") a une partie formant rainure (1e2) qui est prévue sur la surface circonférentielle externe de la partie de forme externe (1e") et est en prise avec la partie formant saillie (1e2).

7. Dispositif de prise de vues selon la revendication 5, dans lequel la partie formant saillie (1e1) a une forme étroite qui est effilée vers le bas, et la partie formant rainure (4b1) a une forme correspondant à la forme étroite de la partie formant saillie (1e1).

8. Dispositif de prise de vues selon la revendication 1, comprenant en outre un élément de cache (5) qui est attaché sur l'élément de cadre externe (4) et est fixé en appliquant une force de pression déterminée sur l'élément presseur (7).

9. Dispositif de prise de vues selon la revendication 8, dans lequel l'élément de cache (5) et l'élément presseur (7) sont réunis solidement.
